# EUROPEAN PATENT SPECIFICATION

(11) **EP 3 088 987 B1**
(45) Date of publication and mention of the grant of the patent: **23.05.2018**
(21) Application number: 16167123.5
(22) Date of filing: 26.04.2016
(51) Int. Cl.: G06F 1/20, H05K 7/20

(54) **COOLING SYSTEM FOR A PROCESSOR**
KÜHLSYSTEM FÜR EINEN PROZESSOR
SYSTÈME DE REFROIDISSEMENT D'UN PROCESSEUR

(30) Priority: 29.04.2015 US 201514699960
(43) Date of publication of application: 02.11.2016
(73) Proprietor: Toshiba TEC Kabushiki Kaisha, Tokyo 141-8562 (JP)
(72) Inventor: KATO, Kazunori, Shinagawa-ku, Tokyo 141-8562 (JP)
(74) Representative: Takeuchi, Maya

(56) References cited:
- DE-A1-102009 031 553
- US-A1- 2007 047 199
- US-A1- 2009 208 192
- US-A1- 2012 155 040

## Description

### FIELD

Embodiments described herein relate generally to a cooling system for a processor and a computing device having the same.

### BACKGROUND

Generally, a circuit board used for a computing device includes a cooling unit, such as a cooling fan, to cool off a processor. Typically an output level of the cooling unit, e.g., a rotational rate of the cooling fan, is controlled based on a control program that is pre-installed in a storage unit of the circuit board. The manufacturer or the user of the computing device wants to adjust the output level of the cooling unit, for example, when the noise generated by the cooling unit operated under the pre-installed program is too large to be used in a quiet environment. However, it is not easy to adjust the output level by modifying the pre-installed program.

DE102009031553A1 discloses a method for a fan configuration in a housing of a computer system, using variable connections to a control panel connector. US2009/0208192A discloses a device for controlling rotation speed of a computer fan, the device including a fan type identifying device and a control circuit.

US2012/0155040A discloses an electronic device comprising an electronic substrate disposed with electronic components housed inside a case, grounded by way of screws. US2007/0047199A discloses an information processing apparatus including a cooling fan and a cooling control method.

### BRIEF DESCRIPTION OF THE DRAWINGS

Fig. 1 illustrates one example of an internal structure of a cooling system according to the embodiment.
Fig. 2 is a control block diagram of the cooling system according to the embodiment.
Fig. 3A illustrates a table A stored in the cooling system according to the embodiment.
Fig. 3B illustrates a table B stored in the cooling system according to the embodiment.
Fig. 4 is a flow chart of an operation carried out by a control unit of the cooling system according to the embodiment.

### DETAILED DESCRIPTION

According to embodiments, a cooling system for a processor includes a base member that is electrically grounded, a circuit board having a first terminal and a second terminal that is electrically separated from the first terminal, one of the first and second terminals being secured and electrically connected to the base member, a cooling unit configured to be operated in a first mode in response to a first control signal and in a second mode in response to a second control signal, and a control unit configured to output the first control signal when the first terminal is secured and electrically connected to the base member and the second control signal when the second terminal is secured and electrically connected to the base member.

Advantageously and in a non-limiting manner, the one of the first and second terminals is secured and electrically connected to the base member with a screw.

Advantageously and in a non-limiting manner, the cooling system further comprises:
a storage unit storing a first data table and a second data table, wherein the control unit outputs the first control signal based on the first data table and the second control signal based on the second data table.

Advantageously and in a non-limiting manner, the cooling system further comprises:
a temperature detecting unit configured to detect a temperature, wherein the first data table indicates a relationship between a temperature and an output value of the first control signal,
the second data table indicates a relationship between a temperature and an output value of the second control signal, and the control unit outputs the first or the second control signal having a value based on the detected temperature and the first or the second data table.

Advantageously and in a non-limiting manner, the cooling unit is a fan, and a rotational rate of the fan is controlled by the first and second control signals.

Advantageously and in a non-limiting manner, an output of the cooling unit in the first mode is different from an output of the cooling unit in the second mode.

Advantageously and in a non-limiting manner, a noise generated by the cooling unit in the first mode is different from a noise generated by the cooling unit in the second mode.

Advantageously and in a non-limiting manner, the circuit board is a motherboard. Particularly, the motherboard is receiving the processor to cool.

The invention also relates to a method for assembling a cooling system for a processor, the method comprising: positioning a circuit board above a base member that is electrically grounded, the circuit board having a first terminal and a second terminal that is electrically separated from the first terminal;
connecting, to the circuit board, a control unit configured to output a first control signal when the first terminal is secured and electrically connected to the base member and a second control signal when the second terminal is secured and electrically connected to the base member;
connecting, to the control unit, a cooling unit configured to be operated in a first mode in response to the first control signal and in a second mode in response to the second control signal; and
securing and electrically connecting one of the first and second terminals to the base member.

Advantageously and in a non-limiting manner, the one of the first and second terminals is secured and electrically connected to the base member with a screw.

Advantageously and in a non-limiting manner, the method further comprises:
connecting, to the control unit, a storage unit storing a first data table and a second data table, such that the control unit outputs the first control signal based on the first data table and the second control signal based on the second data table.

Advantageously and in a non-limiting manner, the method further comprises:
connecting, to the control unit, a temperature detecting unit configured to detect a temperature, such that the control unit outputs the control signal based on the detected temperature.

Advantageously and in a non-limiting manner, the cooling unit is a fan, and a rotational rate of the fan is controlled by the first and second control signals.

Advantageously and in a non-limiting manner, an output of the cooling unit in the first mode is different from an output of the cooling unit in the second mode.

Advantageously and in a non-limiting manner, a noise generated by the cooling unit in the first mode is different from a noise generated by the cooling unit in the second mode.

Advantageously and in a non-limiting manner, the base member is secured and electrically connected to one of the first and second terminals, based on a level of noise generated by the cooling unit.

Advantageously and in a non-limiting manner, the processor is disposed on the circuit board, and the base member is secured and electrically connected to one of the first and second terminals, based on a processing speed of the processor.

Advantageously and in a non-limiting manner, the method further comprises housing the base member and the circuit board in a housing, wherein the base member is secured and electrically connected to one of the first and second terminals, based on a size of the housing.

The invention also relates, in an embodiment, to a computing device comprising:
an operational unit configured to receive a user input;
a display unit;
a processing unit configured to control the operational unit and the display unit, the processing unit including:
   a base member that is electrically grounded,
   a circuit board having a first terminal and a second terminal that is electrically separated from the first terminal, one of the first and second terminals being secured and electrically connected to the base member,
   a cooling unit configured to be operated in a first mode in response to a first control signal and in a second mode in response to a second control signal, and
   a control unit configured to output the first control signal when the first terminal is secured and electrically connected to the base member and the second control signal when the second terminal is secured and electrically connected to the base member.

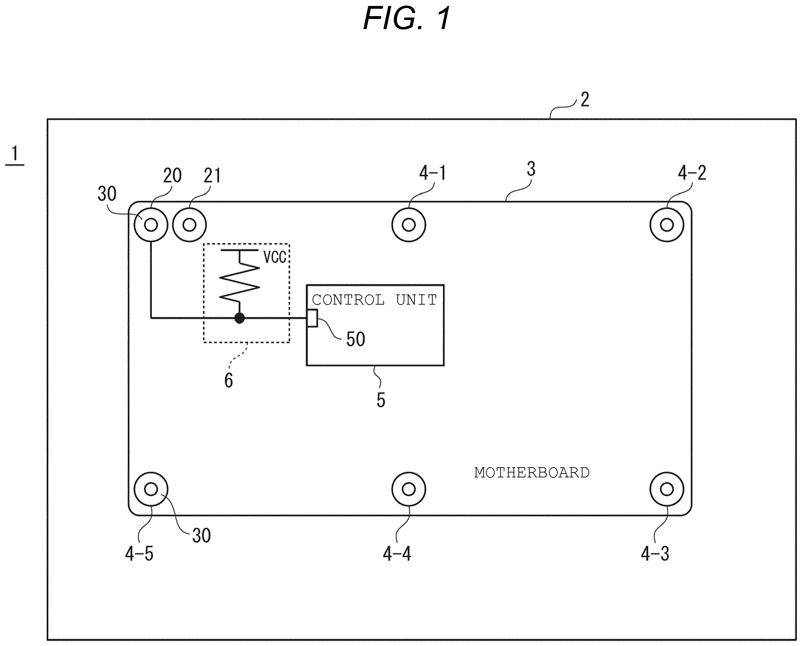

Hereinafter, an electronic circuit device according to the embodiment will be described with reference to the drawings . Fig. 1 illustrates one example of an internal structure of an electronic circuit device 1 according to an embodiment. For example, the electronic circuit device 1 is applied to a Point Of Sale (POS) terminal device.

The electronic circuit device 1 according to the embodiment switches an airflow amount of a cooling fan to cool a CPU of the electronic circuit device 1 depending on conditions including a first condition and a second condition. For example, the first condition is that the electronic circuit device 1 is used in a quiet atmosphere. The second condition is that the electronic circuit device 1 is used in an environment noisier than an ordinary environment.

The electronic circuit device 1 includes a ground plane (base member) 2 and an electronic circuit substrate (board) 3. The ground plane 2 is a metal plate for fixing the electronic circuit substrate 3. The ground plane 2 has seven screw holes for fixing the electronic circuit substrate 3 with screws.

The electronic circuit substrate 3 includes a plurality of fixing holes (fixing holes 4-1 to 4-5, fixing hole 20, and fixing hole 21), a control unit 5, and a signal generating unit (output unit) 6. For example, the electronic circuit substrate 3 is a mother board.

On the electronic circuit substrate 3, the fixing holes 4-1 to 4-5, the fixing hole 20, and the fixing hole 21 are formed at positions corresponding to the screw holes on the ground plane 2.

Each of the fixing holes is a through-hole formed in a pattern 30. The pattern 30 is electrically connected to the ground plane 2 through screws that are disposed in the fixing holes to fix the electronic circuit substrate 3 to the ground plane 2.

When the electronic circuit substrate 3 is fixed on the ground plane 2 through the screws, the ground plane 2 and the pattern 30 of the plural fixing holes 40 are electrically connected with each other through the screws. In other words, when the fixing holes of the electronic circuit substrate 3 are fixed to the ground plane 2 with the screws, the potential of the screwed pattern 30 becomes a ground level.

In the case of the first condition, the electronic circuit substrate 3 is screwed to the ground plane 2 by inserting the screws into the fixing holes 4-1 to 4-5 and the fixing hole 20. As a result, the electronic circuit substrate 3 is fixed to the ground plane 2. In the case of the second condition, the electronic circuit substrate 3 is screwed to the ground plane 2 by inserting the screws into the fixing holes 4-1 to 4-5 and the fixing hole 21. As a result, the electronic circuit substrate 3 is fixed to the ground plane 2. Under the first condition, the potential of the pattern 30 of the fixing holes 4-1 to 4-5 and the fixing hole 20 becomes the ground level. Under the second condition, the potential of the pattern 30 of the fixing holes 4-1 to 4-5 and the fixing hole 21 becomes the ground level.

The pattern 30 having the fixing hole 20 is connected to the signal generating unit 6.

The signal generating unit 6 is provided on the electronic circuit substrate 3. The signal generating unit 6 supplies a control signal to the control unit 5 according to the potential level of the pattern 30 coupled with the fixing hole 20. For example, the signal generating unit 6 is a pull-up resistor or a pull-down resistor. In that case, a connection line for connecting the pattern 30 coupled with the fixing hole 20 and the control unit 5 is connected to a power VCC through the pull-up resistor. In the case of the first condition, the signal generating unit 6 supplies the control signal of low level to the control unit 5. In the case of the second condition, the signal generating unit 6 supplies the control signal of high level to the control unit 5.

The control unit 5 includes an input terminal 50. The control unit 5 is provided on the electronic circuit substrate 3. The input terminal 50 is a General Purpose Input/Output (GPIO) interface. In the embodiment, the input terminal 50 is defined as an input interface. The control signal generated in the signal generating unit 6 is supplied to the input terminal 50. The control unit 5 changes the airflow amount of the cooling fan 13 depending on whether the control signal supplied to the input terminal 50 is at a high level or a low level.

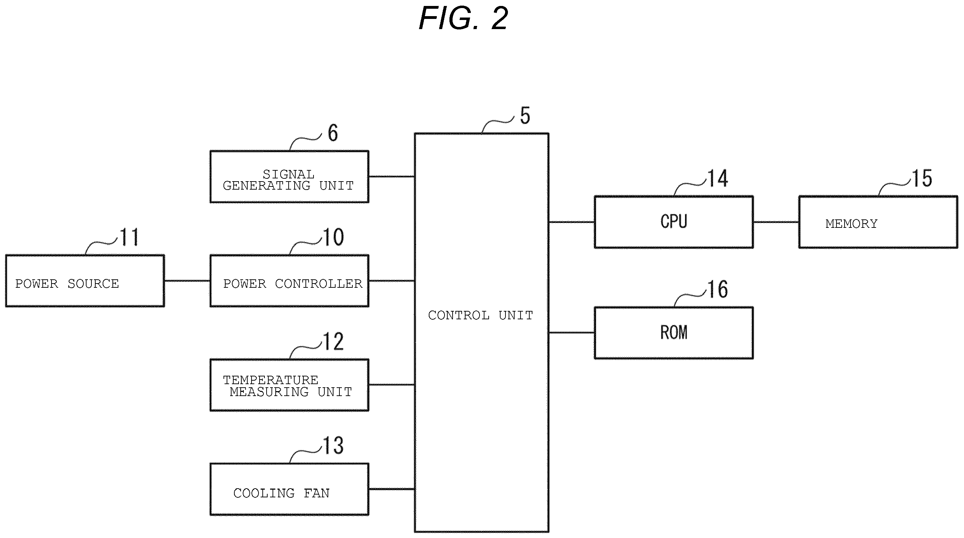

Fig. 2 is a control block diagram of the electronic circuit device 1 according to the embodiment.

The control unit 5 is connected to the signal generating unit 6, a power controller 10, a power source 11, a temperature measuring unit 12, a cooling fan 13, a CPU (Central Processing Unit) 14, a memory 15, and a ROM (Read Only Memory) 16.

The power controller 10 is connected to the power source 11. The power controller 10 controls the supply of electricity supplied from the power source 11 to each unit of the electronic circuit device 1.

The temperature measuring unit 12 measures the temperature of the CPU 14. For example, the temperature measuring unit 12 is a thermal diode built in the CPU 14. The temperature measuring unit 12 supplies signals corresponding to the temperature of the CPU 14 periodically to the control unit 5.

Output of the cooling fan 13 that cools the CPU 14 is changed according to the temperature of the CPU 14 measured by the temperature measuring unit 12. Further, the cooling fan 13 includes a power supply line, a ground line, a driving signal line, and a sensor line. The cooling fan 13 receives the power from the power source 11 through the power supply line. The cooling fan 13 receives the driving signal from the control unit 5 through the driving signal line. The cooling fan 13 generates an air flow while rotating at the rotational rate based on the driving signal supplied from the control unit 5. According to this, the cooling fan 13 cools the CPU 14. For example, the driving signal is a direct current voltage signal having a constant voltage value in accordance with the rotational rate of the cooling fan 13 or a Pulse Width Modulation (PWM) signal having a duty ratio in accordance with the rotational rate of the cooling fan 13. In the embodiment, a PWM signal having a duty ratio is used as the driving signal.

The cooling fan 13 supplies a signal corresponding to the rotational rate of the cooling fan 13 to the control unit 5 through the sensor line.

The CPU 14 is an electronic circuit mounted on the electronic circuit substrate 3. The CPU 14 controls the whole operation of the electronic circuit device 1 through the control unit 5.

The CPU 14 reads out a predetermined program stored in the ROM 16 and develops the program in the memory 15. The CPU 14 controls the operations of the respective units of the electronic circuit device 1 according to the above program. For example, a predetermined program is a Basic Input Output System (BIOS). The BIOS is a program in which a routine for controlling hardware of a system is systematized.

The ROM 16 is a memory which is nonvolatile and in which stored contents can be electrically rewritten.

A control table for controlling the BIOS and the cooling fan 13 is stored in the ROM 16. The BIOS operates at the power-on of the electronic circuit device 1. The BIOS develops in the memory 15 the operating system stored in a hard disk (not illustrated) and the BIOS starts the operating system.

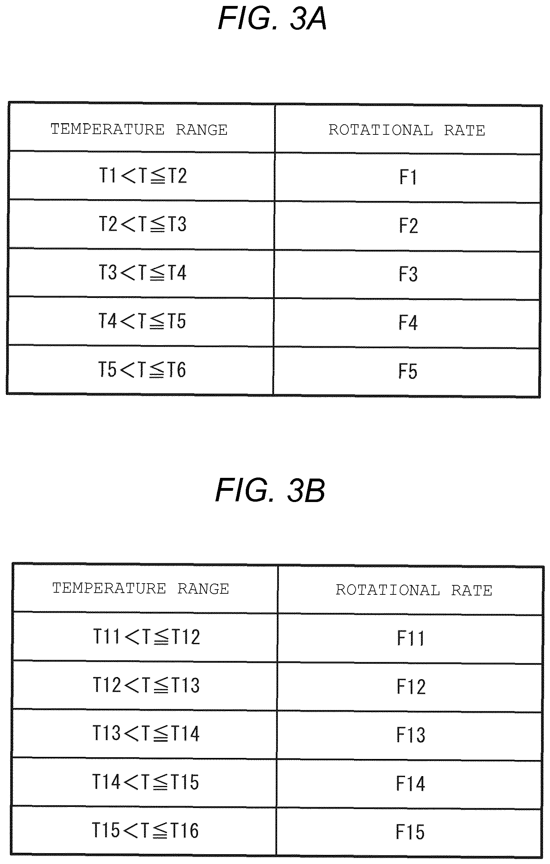

Fig. 3A illustrates one example of the control table (hereinafter, referred to as a "table A") used when the control signal supplied to the input terminal 50 of the control unit 5 is at a high level. Fig. 3B illustrates one example of the control table (hereinafter, referred to as a "table B") used when the control signal supplied to the input terminal 50 of the control unit 5 is at a low level.

In the control table, a temperature range of temperature T of the CPU 14 is correlated with a control parameter. For example, the control parameter is a rotational rate. In the control table, a plurality of various temperature ranges are set as the temperature ranges of the temperature T of the CPU 14. The rotational rate is the number of rotations of the cooling fan 13 per a unit length of time. The rotational rate is set to be higher as the temperature T of the CPU 14 becomes higher. In other words, the rotational rate of the cooling fan 13 is correlated with the temperature range so that a cooling level is be enhanced by increasing the airflow amount as the temperature T of the CPU 14 becomes higher. In the example of illustrated in the table A, the rotational rates F1,..., F5 are correlated with the temperature ranges T1<T≤T2,..., T5<T≤T6, respectively. In the table A, the temperature ranges and the rotational rates corresponding to the second condition are previously set.

In an example illustrated in the table B, the rotational rates F11,..., F15 are correlated with the temperature range T11<T≤T12,..., T15<T≤T16, respectively. In the table B, the temperature ranges and the rotational rates corresponding to the first condition are previously set. As described above, the control table to be used varies according to the potential level of the control signal supplied to the input terminal 50.

The control unit 5 determines whether the potential level of the input terminal 50 is at a high level or a low level at a predetermined timing. When the potential level of the input terminal 50 is at a high level, the control unit 5 reads out the table A from the ROM 16. On the other hand, when the potential level of the input terminal 50 is at a low level, the control unit 5 reads out the table B from the ROM 16. For example, the predetermined timing is an executing time of the BIOS processing.

The control unit 5 obtains the temperature T of the CPU 14 based on the signal from the temperature measuring unit 12. The control unit 5 obtains the rotational rate of the cooling fan 13 from the control table, after determining in which temperature range the obtained temperature T is included. The control unit 5 generates a driving signal in accordance with the obtained rotational rate and supplies the generated driving signal to the cooling fan 13.

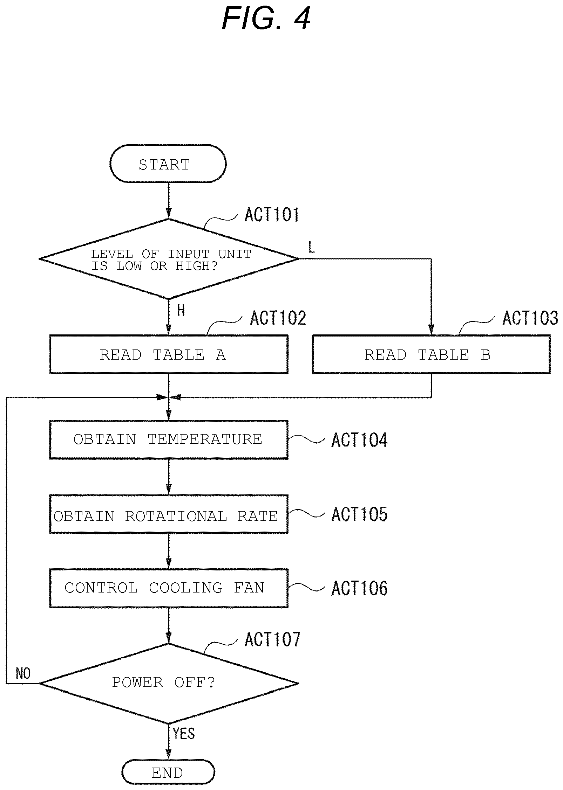

Next, the operation of the control unit 5 will be described with reference to the drawings. Fig. 4 illustrates one example of an operation carried out by the control unit 5.

The control unit 5 determines whether the potential level at the input terminal 50 is a high level or a low level at a predetermined timing (ACT 101).

When the potential level of the input terminal 50 is a high level, the control unit 5 reads out the table A from the ROM 16 (ACT 102). When the potential level of the input terminal 50 is a low level, the control unit 5 reads out the table B from the ROM 16 (ACT 103).

The control unit 5 obtains the temperature T of the CPU 14 based on the signal from the temperature measuring unit 12 (ACT 104). The control unit 5 determines in which temperature range the obtained temperature T is, in the control table. The control unit 5 obtains the rotational rate corresponding to the determined temperature range (ACT 105).

The control unit 5 generates a driving signal in accordance with the obtained rotational rate and supplies the generated driving signal to the cooling fan 13 (ACT 106) . Thus, the cooling fan 13 is operated to cool the CPU 14.

The control unit 5 determines whether or not the power to the electronic circuit device is turned off (ACT 107) . When the control unit 5 determines that the power is turned off (ACT 107: YES), the power controller 10 stops the supply of electricity from the power source 11 to the respective units of the electronic circuit device 1. When the control unit 5 determines that the power is not turned off (ACT 107: NO), the control unit 5 executes the processing of ACT 104 again. In other words, the control unit 5 periodically executes the processing from ACT 104 to ACT 106 until the power is turned off.

According to at least one embodiment as described above, the electronic circuit device 1 according to the embodiment includes the ground plane 2, the electronic circuit substrate 3, the CPU 14, the cooling fan 13, the signal generating unit 6, and the control unit 5. The electronic circuit substrate 3 has the pattern 30 to be connected to the ground plane 2 through the screws that are disposed in the fixing holes, to be fixed to the ground plane 2. The CPU 14 is disposed on the electronic circuit substrate 3. The cooling fan 13 generates airflow toward the CPU 14 by rotating at the rotational rate in accordance with the driving signal. The signal generating unit 6 creates a control signal based on the potential of the pattern 30 of the fixing hole 20. The control unit 5 obtains a control parameter for controlling the cooling fan 13 based on the control signal and supplies a driving signal to the cooling fan 13 based on the obtained parameter. As the result, the driving signal to control the cooling fan 13 can be easily changed by inserting a screw into the fixing hole 20 or the fixing hole 21 according to the condition.

For example, when the first condition is for the quiet environment and the second condition is for an environment that is noisier than ordinary environment, the cooling fan 13 can be controlled in accordance with the environment where the electronic circuit device 1 is set, based on the position of the screw.

For example, the first condition corresponds to the case of the CPU 14 having a high processing speed. The second condition corresponds to the case of the CPU 14 having a low processing speed. The temperature of the CPU is apt to become higher as the processing speed becomes higher. Therefore, by inserting a screw into the fixing hole 20 or the fixing hole 21 according to the processing speed of the CPU 14, the cooling fan can be controlled according to the processing speed of the CPU 14.

For example, the first condition corresponds to the case where a housing of the electronic circuit device 1 is large. The second condition corresponds to the case where the housing of the electronic circuit device 1 is small. The temperature of the CPU is apt to become higher as the housing of the electronic circuit device 1 becomes smaller. Therefore, it is possible to control the cooling fan in accordance with the size of the housing, by inserting the screw into the fixing hole 20 or the fixing hole 21 depending on the size of the housing of the electronic circuit device 1.

In the above-described embodiment, the number of the screws holes provided in the ground plane 2 is the same as the number of the fixing holes; however, this is not limited. For example, when a screw is inserted in the fixing hole 20 in the manufacturing process, it may be designed not to provide any screw hole corresponding to the fixing hole 21 in the ground plane 2. According to this, when the housing of the electronic circuit device 1 is large, erroneously inserting the screw in the fixing hole prepared to control the cooling fan in a small housing can be prevented.

In the above-described embodiment, the airflow amount of the cooling fan is controlled depending on the potential level of the pattern 30 of one fixing hole 20; however the number of the pattern 30 used for the controlling is not limited to one. For example, the airflow amount of the cooling fan may be controlled according to the potential level of the patterns 30 of two and more fixing holes.

In the above-described embodiment, a control parameter is obtained according to the temperature of the CPU 14 but not limited to this. For example, a control parameter may be obtained according to the load current or the power consumption of the CPU 14.

In the above-described embodiment, the control unit 5 controls the airflow amount of the cooling fan 13 while periodically monitoring the temperature of the CPU 14, but not limited to this. For example, the control unit 5 may control the airflow amount of the cooling fan 13 while monitoring the temperature of the CPU 14 and the rotational rate of the cooling fan 13. Here, the control unit 5 may monitor the rotational rate of the cooling fan 13 using a sensor line.

The electronic circuit device can be applied to a computing device, such as a POS terminal. In such a case, the POS terminal includes an input unit, a calculation (processing) unit, a display unit, and a printer. The input unit is to enter the type and the price of sales merchandise. The calculation unit calculates the total amount of money for the entered merchandise. The display unit displays the sold merchandise name and price and the total price. The printer prints out the name and the price of the merchandise and the total price displayed on the screen of the display unit.

The whole or a part of the functions of the above-described control unit may be stored in a computer readable recording medium to be achieved. The program stored in the recording medium may be realized and executed by the CPU 14.

The "computer readable recording medium" means a transportable medium and storing unit. For example, the portable medium includes a flexible disk, an optical magnetic disk, ROM, and CD-ROM. For example, the storing unit is a hard disk built in the computer system. Further, the "computer readable recording medium" is to hold a program dynamically during a short time and for a predetermined period. For example, a network is the Internet. For example, the medium to hold a program dynamically indicates a communication line when a program is transmitted through a communication line. For example, the medium to hold a program for a predetermined period is a server or a volatile memory within the computer system that becomes a client. The above program may be one to achieve a part of the above-described functions. Further, the above-described functions may be achieved by combination with a program already stored in the computer system.

While certain embodiments have been described, these embodiments have been presented by way of example only, and are not intended to limit the scope of the inventions. Indeed, the novel embodiments described herein may be embodied in a variety of other forms; furthermore, various omissions, substitutions, and changes in the form of the embodiments described herein may be made without departing from the framework of the invention as defined in the claims. The accompanying claims are intended to cover such forms or modifications as would fall within the scope of the invention.

## Claims

1. A cooling system (1) for a processor comprising:
a base member (2) that is electrically grounded;
a circuit board (3) having a first terminal (20) and a second terminal (21) that is electrically separated from the first terminal (20), one of the first (20) and second (21) terminals being secured and electrically connected to the base member (2);
a cooling unit (13) configured to be operated in a first mode in response to a first control signal and in a second mode in response to a second control signal; and
a control unit (5) configured to output the first control signal when the first terminal is secured and electrically connected to the base member and the second control signal when the second terminal is secured and electrically connected to the base member.

2. The cooling system (1) according to claim 1, wherein
the one of the first (20) and second (21) terminals is secured and electrically connected to the base member (2) with a screw.

3. The cooling system (1) according to claim 1 or 2, further comprising:
a storage unit (16) storing a first data table (A) and a second data table (B), wherein
the control unit (5) outputs the first control signal based on the first data table (A) and the second control signal based on the second data table (B).

4. The cooling system (1) according to claim 3, further comprising:
a temperature detecting unit (12) configured to detect a temperature, wherein
the first data table (A) indicates a relationship between a temperature and an output value of the first control signal,
the second data table (B) indicates a relationship between a temperature and an output value of the second control signal, and
the control unit (5) outputs the first or the second control signal having a value based on the detected temperature and the first or the second data table.

5. The cooling system (1) according to any one of claims to 1 to 4, wherein
the cooling unit (13) is a fan, and
a rotational rate of the fan is controlled by the first and second control signals.

6. The cooling system (1) according to any one of claims 1 to 5, wherein
an output of the cooling unit (13) in the first mode is different from an output of the cooling unit (13) in the second mode.

7. The cooling system (1) according to any one of claims 1 to 6, wherein
a noise generated by the cooling unit (13) in the first mode is different from a noise generated by the cooling unit (13) in the second mode.

8. The cooling system (1) according to any one of claims 1 to 7, wherein
the circuit board (3) is a motherboard (3) receiving a processor.

9. A method for assembling a cooling system (1) for a processor, the method comprising:
positioning a circuit board (3) above a base member (2) that is electrically grounded, the circuit board (3) having a first terminal (20) and a second terminal (21) that is electrically separated from the first terminal (20);
connecting, to the circuit board (3), a control unit (5) configured to output a first control signal when the first terminal (20) is secured and electrically connected to the base member (2) and a second control signal when the second terminal (21) is secured and electrically connected to the base member (2);
connecting, to the control unit (5), a cooling unit (13) configured to be operated in a first mode in response to the first control signal and in a second mode in response to the second control signal; and
securing and electrically connecting one of the first (20) and second (21) terminals to the base member (2).

10. The method according to claim 9, wherein
the one of the first (20) and second (21) terminals is secured and electrically connected to the base member (2) with a screw.

11. The method according to claim 9 or 10, further comprising:
connecting, to the control unit (5), a storage unit (16) storing a first data table (A) and a second data table (B), such that the control unit outputs the first control signal based on the first data table and the second control signal based on the second data table.

12. The method according to any one of claims 9 to 11, further comprising:
connecting, to the control unit (5), a temperature detecting unit (12) configured to detect a temperature, such that the control unit (5) outputs the control signal based on the detected temperature.

13. The method according to any one of claims 9 to 12, wherein
the base member (2) is secured and electrically connected to one of the first (20) and second terminals (21), based on a level of noise generated by the cooling unit (13).

14. The method according to any one of claims 9 to 13, further comprising:
housing the base member (2) and the circuit board (3) in a housing, wherein
the base member (2) is secured and electrically connected to one of the first (20) and second (21) terminals, based on a size of the housing.

15. A computing device comprising:
an operational unit configured to receive a user input;
a display unit;
a processing unit configured to control the operational unit and the display unit, the processing unit including a cooling system (1) according to any one of claims 1 to 8.

## Patentansprüche

1. Kühlsystem (1) für einen Prozessor, umfassend:
ein Basisglied (2), das elektrisch geerdet ist;
eine Leiterplatte (3) mit einem ersten Anschluss (20) und einem zweiten Anschluss (21), der elektrisch von dem ersten Anschluss (20) getrennt ist, wobei einer des ersten (20) und des zweiten (21) Anschlusses an dem Basisglied (2) gesichert bzw. befestigt und elektrisch mit diesem verbunden ist;
eine Kühleinheit (13), die konfiguriert ist, als Antwort auf ein erstes Steuer- bzw. Regelsignal in einem ersten Modus und als Antwort auf ein zweites Steuer- bzw. Regelsignal in einem zweiten Modus betrieben zu werden; und
eine Steuer- bzw. Regeleinheit (5), die konfiguriert ist, das erste Steuer- bzw. Regelsignal, wenn der erste Anschluss an dem Basisglied gesichert bzw. befestigt und elektrisch mit diesem verbunden ist, und das zweite Steuer- bzw. Regelsignal auszugeben, wenn der zweite Anschluss an dem Basisglied gesichert bzw. befestigt und elektrisch mit diesem verbunden ist.

2. Kühlsystem (1) nach Anspruch 1, wobei der eine des ersten (20) und des zweiten (21) Anschlusses mit einer Schraube an dem Basisglied (2) befestigt und elektrisch mit diesem verbunden ist.

3. Kühlsystem (1) nach Anspruch 1 oder 2, ferner umfassend:
eine Speichereinheit (16), die eine erste Datentabelle (A) und eine zweite Datentabelle (B) speichert, wobei
die Steuer- bzw. Regeleinheit (5) das erste Steuer- bzw. Regelsignal basierend auf der ersten Datentabelle (A) und das zweite Steuer- bzw. Regelsignal basierend auf der zweiten Datentabelle (B) ausgibt.

4. Kühlsystem (1) nach Anspruch 3, ferner umfassend:
eine Temperaturerfassungseinheit (12), die konfiguriert ist, eine Temperatur zu erfassen, wobei
die erste Datentabelle (A) eine Beziehung zwischen einer Temperatur und einem Ausgabewert des ersten Steuer- bzw. Regelsignals angibt,
die zweite Datentabelle (B) eine Beziehung zwischen einer Temperatur und einem Ausgabewert des zweiten Steuer- bzw. Regelsignals angibt und
die Steuer- bzw. Regeleinheit (5) das erste oder das zweite Steuer- bzw. Regelsignal mit einem Wert basierend auf der erfassten Temperatur und der ersten oder der zweiten Datentabelle ausgibt.

5. Kühlsystem (1) nach einem der Ansprüche 1 bis 4, wobei
die Kühleinheit (13) ein Lüfter ist und
eine Drehgeschwindigkeit bzw. -rate des Gebläses wird durch das erste und das zweite Steuer- bzw. Regelsignal gesteuert bzw. geregelt wird.

6. Kühlsystem (1) nach einem der Ansprüche 1 bis 5, wobei sich eine Ausgabe der Kühleinheit (13) in dem ersten Betriebsmodus von einer Ausgabe der Kühleinheit (13) in dem zweiten Betriebsmodus unterscheidet.

7. Kühlsystem (1) nach einem der Ansprüche 1 bis 6, wobei sich ein von der Kühleinheit (13) in dem ersten Betriebsmodus erzeugtes Geräusch von einem Geräusch unterscheidet, das von der Kühleinheit (13) in dem zweiten Betriebsmodus erzeugt wird.

8. Kühlsystem (1) nach einem der Ansprüche 1 bis 7, wobei die Leiterplatte (3) eine Hauptplatine bzw. Motherboard (3) ist, die bzw. das einen Prozessor aufnimmt.

9. Verfahren zum Montieren eines Kühlsystems (1) für einen Prozessor, wobei das Verfahren umfasst:
Positionieren einer Leiterplatte (3) über einem Basisglied (2), das elektrisch geerdet ist, wobei die Leiterplatte (3) einen ersten Anschluss (20) und einen zweiten Anschluss (21) aufweist, der elektrisch von dem ersten Anschluss (20) getrennt ist;
Verbinden, mit der Leiterplatte (3), einer Steuer- bzw. Regeleinheit (5), die konfiguriert ist, ein erstes Steuer- bzw. Regelsignal, wenn der erste Anschluss (20) an dem Basisglied (2) gesichert bzw. befestigt und elektrisch mit diesem verbunden ist, und ein zweites Steuer- bzw. Regelsignal auszugeben, wenn das zweite der Anschluss (21) an dem Basisglied (2) gesichert bzw. befestigt und elektrisch mit diesem verbunden ist;
Verbinden, mit der Steuer- bzw. Regeleinheit (5), einer Kühleinheit (13), die konfiguriert ist, als Antwort auf das erste Steuer- bzw. Regelsignal in einem ersten Modus und als Antwort auf das zweite Steuer- bzw. Regelsignal in einem zweiten Modus betrieben zu werden; und
Sichern bzw. Befestigen und elektrisches Verbinden eines des ersten (20) und des zweiten (21) Anschlusses mit dem Basisglied (2).

10. Verfahren nach Anspruch 9, wobei der eine des ersten (20) und des zweiten (21) Anschlusses mit einer Schraube an dem Basisglied (2) befestigt und elektrisch mit diesem verbunden wird.

11. Verfahren nach Anspruch 9 oder 10, ferner umfassend:
Verbinden, mit der Steuer- bzw. Regeleinheit (5), einer Speichereinheit (16), die eine erste Datentabelle (A) und eine zweite Datentabelle (B) speichert, so dass die Steuer- bzw. Regeleinheit das erste Steuer- bzw. Regelsignal basierend auf der ersten Datentabelle und das zweite Steuer- bzw. Regelsignal basiert auf der zweiten Datentabelle ausgibt.

12. Verfahren nach einem der Ansprüche 9 bis 11, ferner umfassend:
Verbinden, mit der Steuer- bzw. Regeleinheit (5), einer Temperaturerfassungseinheit (12), die konfiguriert ist, eine Temperatur zu erfassen, so dass die Steuer- bzw. Regeleinheit (5) das Steuer- bzw. Regelsignal basierend auf der erfassten Temperatur ausgibt.

13. Verfahren nach einem der Ansprüche 9 bis 12, wobei das Basisglied (2) an einem des ersten (20) und des zweiten (21) Anschlusses gesichert bzw. befestigt und elektrisch mit diesem verbunden wird, und zwar basierend auf einem Geräuschpegel, der von der Kühleinheit (13) erzeugt wird.

14. Verfahren nach einem der Ansprüche 9 bis 13, ferner umfassend:
Unterbringen des Basisglieds (2) und der Leiterplatte (3) in einem Gehäuse, wobei
wobei das Basisglied (2) an einem des ersten (20) und des zweiten (21) Anschlusses gesichert bzw. befestigt und elektrisch mit diesem verbunden wird, und zwar basierend auf einer Größe des Gehäuses.

15. Rechenvorrichtung, umfassend:
eine Betriebseinheit, die konfiguriert ist, eine Benutzereingabe zu empfangen;
eine Anzeigeeinheit;
eine Verarbeitungseinheit, die konfiguriert ist, die Betriebseinheit und die Anzeigeeinheit zu steuern bzw. zu regeln, wobei die Verarbeitungseinheit ein Kühlsystem (1) nach einem der Ansprüche 1 bis 8 umfasst.

## Revendications

1. Dispositif de refroidissement (1) destiné à une unité de traitement comprenant :
un élément de base (2) qui est raccordé électriquement à la masse ;
une carte de circuit (3) comportant une première borne (20) et une seconde borne (21) qui est isolée électriquement de la première borne (20), l'une des première (20) et seconde (21) bornes étant fixée sur l'élément de base (2) et raccordée électriquement à celui-ci ;
une unité de refroidissement (13) configurée de manière à être commandée dans un premier mode en réponse à un premier signal de commande et un second mode en réponse à un second signal de commande ; et
une unité de commande (5) configurée de manière à délivrer le premier signal de commande lorsque la première borne est fixée sur l'élément de base et raccordée électriquement à celui-ci et le second signal de commande lorsque la seconde borne est fixée sur l'élément de base et raccordée électriquement à celui-ci.

2. Dispositif de refroidissement (1) selon la revendication 1, dans lequel l'une des première (20) et seconde (21) bornes est fixée sur l'élément de base (2) et raccordée électriquement à celui-ci au moyen d'une vis.

3. Dispositif de refroidissement (1) selon la revendication 1 ou 2, comprenant, en outre :
une unité de mémorisation (16) mémorisant une première table de données (A) et une seconde table de données (B), dans lequel
l'unité de commande (5) délivre le premier signal de commande sur la base de la première table de données (A) et le second signal de commande sur la base de la seconde table de données (B).

4. Dispositif de refroidissement (1) selon la revendication 3, comprenant, en outre :
une unité de détection de température (12) configurée de manière à détecter une température, dans lequel
la première table de données (A) indique une relation entre une température et une valeur de sortie du premier signal de commande,
la seconde table de données (B) indique une relation entre une température et une valeur de sortie du second signal de commande, et
l'unité de commande (5) délivre le premier ou le second signal de commande présentant une valeur en fonction de la température détectée et de la première ou la seconde table de données.

5. Dispositif de refroidissement (1) selon l'une quelconque des revendications 1 à 4, dans lequel
l'unité de refroidissement (13) est un ventilateur, et
une vitesse de rotation du ventilateur est commandée par les premier et second signaux de commande.

6. Dispositif de refroidissement (1) selon l'une quelconque des revendications 1 à 5, dans lequel
une sortie de l'unité de refroidissement (13) dans le premier mode est différente d'une sortie de l'unité de refroidissement (13) dans le second mode.

7. Dispositif de refroidissement (1) selon l'une quelconque des revendications 1 à 6, dans lequel
un bruit produit par l'unité de refroidissement (13) dans le premier mode est différent d'un bruit produit par l'unité de refroidissement (13) dans le second mode.

8. Dispositif de refroidissement (1) selon l'une quelconque des revendications 1 à 7, dans lequel
la carte de circuit (3) est une carte mère (3) recevant une unité de traitement.

9. Procédé d'assemblage d'un dispositif de refroidissement (1) destiné à une unité de traitement, le procédé comprenant :
le positionnement d'une carte de circuit (3) au-dessus d'un élément de base (2) qui est raccordé électriquement à la masse, la carte de circuit (3) présentant une première borne (20) et une seconde borne (21) qui est isolée électriquement de la première borne (20) ;
le raccordement, sur la carte de circuit (3), d'une unité de commande (5) configurée de manière à délivrer un premier signal de commande lorsque la première borne (20) est fixée sur l'élément de base (2) et raccordée électriquement à celui-ci et un second signal de commande lorsque la seconde borne (21) est fixée sur l'élément de base (2) et raccordée électriquement à celui-ci ;
le raccordement, sur l'unité de commande (5), d'une unité de refroidissement (13) configurée de manière à être commandée dans un premier mode en réponse au premier signal de commande et dans un second mode en réponse au second signal de commande ; et
la fixation de l'une des première (20) et seconde (21) bornes sur l'élément de base (2) et son raccordement électrique sur celui-ci.

10. Procédé selon la revendication 9, dans lequel
l'une des première (20) et seconde (21) bornes est fixée sur l'élément de base (2) et raccordée électriquement à celui-ci au moyen d'une vis.

11. Procédé selon la revendication 9 ou 10, comprenant, en outre :
le raccordement, sur l'unité de commande (5), d'une unité de mémorisation (16) mémorisant une première table de données (A) et une seconde table de données (B), de telle sorte que l'unité de commande délivre le premier signal de commande sur la base de la première table de données et le second signal de commande sur la base de la seconde table de données.

12. Procédé selon l'une quelconque des revendications 9 à 11, comprenant, en outre :
le raccordement, sur l'unité de commande (5), d'une unité de détection de température (12) configurée de manière à détecter une température, de telle sorte que l'unité de commande (5) délivre le signal de commande sur la base de la température détectée.

13. Procédé selon l'une quelconque des revendications 9 à 12, dans lequel l'élément de base (2) est fixé sur l'une des première (20) et seconde bornes (21) et raccordé électriquement sur celle-ci, sur la base d'un niveau de bruit produit par l'unité de refroidissement (13).

14. Procédé selon l'une quelconque des revendications 9 à 13, comprenant, en outre :
l'agencement de l'élément de base (2) et de la carte de circuit (3) dans un logement, dans lequel
l'élément de base (2) est fixé sur l'une des première (20) et seconde (21) bornes et raccordé électriquement sur celle-ci, en fonction d'une dimension du logement.

15. Dispositif informatique comprenant :
une unité opérationnelle configurée de manière à recevoir une entrée d'utilisateur ;
une unité d'affichage ;
une unité de traitement configurée de manière à commander l'unité opérationnelle et l'unité d'affichage, l'unité de traitement comportant un dispositif de refroidissement (1) selon l'une quelconque des revendications 1 à 8.
